# EUROPEAN PATENT APPLICATION

(11) **EP 3 923 102 A1**
(43) Date of publication of application: **15.12.2021**
(21) Application number: 20178939.3
(22) Date of filing: 09.06.2020
(51) Int. Cl.: G05B 23/02, B60L 3/00

(54) **OPTIMIZATION OF MAINTENANCE INTERVAL OF A TROLLEY LINE SYSTEM**

(71) Applicant: Sandvik Mining and Construction Oy, 33330 Tampere (FI)
(72) Inventor: VERHO, Samuli, 33311 Tampere (FI); JUNTUNEN, Raimo, 33330 Tampere (FI)
(74) Representative: Sandvik

(57) **Abstract**

Various example embodiments relate to optimization of a maintenance interval of a trolley line system. Isolation resistance measurement data of the trolley line system may be monitored to predict the isolation resistance of the trolley line system with respect to time. The prediction may be compared to predetermined thresholds for determining the interval for maintenance. An apparatus, a method, and a computer program are disclosed.

## Description

### TECHNICAL FIELD

Various example embodiments generally relate to the field of computer technology. In particular, some example embodiments relate a method and an apparatus configured to predict maintenance interval of a trolley line system and to determine an optimized time slot for the maintenance.

### BACKGROUND

Trolley line systems are used to power electric vehicles for transportation, which are configured to draw power, for example, from dual overhead lines of the system. The trolley line systems with rubber wheel vehicles are usually constructed as an IT system. Therefore, isolation resistance of the trolley line system is required to be continuously monitored. The trolley line systems require regular maintenance, which may be performed in response to the monitored isolation resistance measurements indicating that the isolation resistance has decreased below a recommended value.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Example embodiments provide a method and an apparatus for to determining an interval for maintenance of a trolley line system based on predicted isolation resistance. Further, the method and the apparatus may determine an optimal time slot for the maintenance. These benefits may be achieved by the features of the independent claims. Further implementation forms are provided in the dependent claims, the description, and the drawings.

According to a first aspect, there is provided a method. The method comprises obtaining isolation resistance measurement data associated to a trolley line system; determining a rate of change of the isolation resistance based on the isolation resistance measurement data; predicting isolation resistance of the trolley line system with respect to time based on the rate of change; determining one or more isolation resistance thresholds indicative of a condition of the isolators; and determining an interval for maintenance of the isolators based on the predicted isolation resistance and the one or more isolation resistance thresholds, wherein the interval is indicative of a time when the one or more isolation resistance thresholds are met by the predicted isolation resistance.

In an embodiment, the method comprises determining maintenance of the isolators within the interval for maintenance.

In an embodiment, in addition or alternatively, the method comprises obtaining operation data; determining one or more possible time slots for maintenance based on the operation data; comparing the possible time slots to the interval for maintenance to detect an optimal time slot from the possible time slots, wherein the optimal time slot is located within the interval; and determining the maintenance of the isolators for the optimal time slot.

In an embodiment, in addition or alternatively, the operation data is associated to operations of a production site comprising the trolley line system; and the possible time slot is associated with at least one of a decreased production or a scheduled maintenance at the production site.

In an embodiment, in addition or alternatively, the optimal time slot for maintenance is the earliest possible time slot within the interval.

In an embodiment, in addition or alternatively, the optimal time slot for maintenance is the possible time slot within the interval which has the lowest production.

In an embodiment, in addition or alternatively, the interval for maintenance comprises a primary interval in which the predicted isolation resistance is above a first isolation resistance threshold and a secondary interval in which the predicted isolation resistance is between the first and a second isolation resistance threshold; and wherein the possible time slots are compared to the primary interval; and in response to not detecting possible time slots locating within the primary interval, the possible time slots are compared to the secondary interval.

In an embodiment, in addition or alternatively, the interval for maintenance comprises a third interval in which the predicted isolation resistance is between the second and a third threshold; and in response to not detecting possible time slots locating within the primary and the secondary interval, the possible time slots are compared to the third interval.

In an embodiment, in addition or alternatively, the method comprises determining the maintenance within the primary interval when there are no possible time slots locating within the interval.

In an embodiment, in addition or alternatively, the method comprises determining a typical rate of change of the isolation resistance based on previously measured isolation resistance data of the isolators; comparing the determined rate of change to the typical rate of change to detect deviation from the typical rate of change; and determining a cause of the deviation based on the operation data.

In an embodiment, in addition or alternatively, the method comprises detecting a substantial change in the predicted isolation resistance; and correcting the interval for maintenance based on the substantial change in the predicted isolation resistance and the isolation resistance thresholds.

In an embodiment, in addition or alternatively, the method comprises determining a cause of the substantial change in the predicted isolation resistance based on the operation data.

In an embodiment, in addition or alternatively, the method comprises obtaining information indicating that at least one electric vehicle is coupled with the trolley line system; detecting a decrease in the isolation resistance in response to the at least one electric vehicle being coupled with the trolley line system based on the isolation resistance measurement data; determining the electric vehicle associated with the decrease based on the information; and determining a maintenance of the electric vehicle simultaneously with maintenance of the trolley line system.

According to a second aspect, there is provided an apparatus. The apparatus comprises at least one processor; and at least one memory comprising program code which, when executed by the at least one processor, causes the apparatus at least to obtain isolation resistance measurement data associated to a trolley line system; determine a rate of change of the isolation resistance based on the isolation resistance measurement data; predict isolation resistance of the trolley line system with respect to time based on the rate of change; determine one or more isolation resistance thresholds indicative of a condition of the isolators; and determine an interval for maintenance of the isolators based on the predicted isolation resistance and the one or more isolation resistance thresholds, wherein the interval is indicative of a time when the one or more isolation resistance thresholds are met by the predicted isolation resistance.

In an embodiment, the apparatus is further caused to determine maintenance of the isolators within the interval for maintenance.

In an embodiment, in addition or alternatively, the apparatus is further caused to obtain operation data; determine one or more possible time slots for maintenance based on the operation data; compare the possible time slots to the interval for maintenance to detect an optimal time slot from the possible time slots, wherein the optimal time slot is located within the interval; and determine the maintenance of the isolators for the optimal time slot.

In an embodiment, in addition or alternatively, the operation data is associated to operations of a production site comprising the trolley line system; and the possible time slot is associated with at least one of a decreased production or a scheduled maintenance at the production site.

In an embodiment, in addition or alternatively, the optimal time slot for maintenance is the earliest possible time slot within the interval.

In an embodiment, in addition or alternatively, the optimal time slot for maintenance is the possible time slot within the interval which has the lowest production.

In an embodiment, in addition or alternatively, the interval for maintenance comprises a primary interval in which the predicted isolation resistance is above a first isolation resistance threshold and a secondary interval in which the predicted isolation resistance is between the first and a second isolation resistance threshold; and wherein the possible time slots are compared to the primary interval; and in response to not detecting possible time slots locating within the primary interval, the possible time slots are compared to the secondary interval.

In an embodiment, in addition or alternatively, the interval for maintenance comprises a third interval in which the predicted isolation resistance is between the second and a third threshold; and in response to not detecting possible time slots locating within the primary and the secondary interval, the possible time slots are compared to the third interval.

In an embodiment, in addition or alternatively, the apparatus is further caused to determine the maintenance within the primary interval when there are no possible time slots locating within the interval.

In an embodiment, in addition or alternatively, the apparatus is further caused to determine a typical rate of change of the isolation resistance based on previously measured isolation resistance data of the isolators; compare the determined rate of change to the typical rate of change to detect deviation from the typical rate of change; and determine a cause of the deviation based on the operation data.

In an embodiment, in addition or alternatively, the apparatus is further caused to detect a substantial change in the predicted isolation resistance; and correct the interval for maintenance based on the substantial change in the predicted isolation resistance and the isolation resistance thresholds.

In an embodiment, in addition or alternatively, the apparatus is further caused to determine a cause of the substantial change in the predicted isolation resistance based on the operation data.

In an embodiment, in addition or alternatively, the apparatus is further caused to obtain information indicating that at least one electric vehicle is coupled with the trolley line system; detect a decrease in the isolation resistance in response to the at least one electric vehicle being coupled with the trolley line system based on the isolation resistance measurement data; determine the electric vehicle associated with the decrease based on the information; and determine a maintenance of the electric vehicle simultaneously with maintenance of the trolley line system.

According to a third aspect, there is provided a trolley line system comprising an isolation monitoring device configured to dispatch isolation resistance measurement data associated to the trolley line system to an apparatus of the second aspect.

According to a fourth aspect, there is provided a computer program comprising program code which, when executed by at least one processing unit, causes the at least one processing unit to perform the method according to the first aspect.

In an embodiment, the computer program is embodied in a computer readable medium.

Many of the attendant features will be more readily appreciated as they become better understood by reference to the following detailed description considered in connection with the accompanying drawings.

### DESCRIPTION OF THE DRAWINGS

The accompanying drawings, which are included to provide a further understanding of the example embodiments and constitute a part of this specification, illustrate example embodiments and together with the description help to understand the example embodiments. In the drawings:
FIG. 1 illustrates an apparatus configured to determine an interval for maintenance of a trolley line system according to an embodiment.
FIG. 2 illustrates an example embodiment of a trolley line system according to an embodiment.
FIG. 3 illustrates a support structure of the trolley line system comprising at least one level of isolation according to an embodiment.
FIG. 4 illustrates an example diagram of isolation resistance curves derived from isolation resistance measurement data associated to a trolley line system according to an embodiment.
FIG. 5 illustrates a diagram of operation data and possible time slots for maintenance of a trolley line system within an interval for maintenance according to an embodiment.
FIG. 6 illustrates a diagram of operation data and possible time slots for maintenance within an interval for maintenance according to another embodiment.
FIG. 7 illustrates a diagram of predicted isolation resistance where an optimal time slot for maintenance changes due to a change in the prediction according to an embodiment.
FIG. 8 illustrates a flowchart of operation of an apparatus for determining a maintenance interval of a trolley line system according to an embodiment.

Like references are used to designate like parts in the accompanying drawings.

### DETAILED DESCRIPTION

Reference will now be made in detail to example embodiments, examples of which are illustrated in the accompanying drawings. The detailed description provided below in connection with the appended drawings is intended as a description of the present examples and is not intended to represent the only forms in which the present example may be constructed or utilized. The description sets forth the functions of the example and the sequence of operations for constructing and operating the example. However, the same or equivalent functions and sequences may be accomplished by different examples.

Trolley line systems may be used, for example, in mining industry for haulage by rubber-tired machines. The trolley lines may locate inside a mine or at least partly outside the mine when the haulage route continues out from the mine to an unloading point for ore on surface. Especially in mining environment, dust and moisture may gather on the trolley line system reducing the isolation resistance. As maintenance, the isolators of the trolley line system need to be washed regularly, which means that the trolley line system is out of use during the maintenance. Trolley lines may be long and every isolated support point comprising the isolators may reduce the total isolation resistance. This increases the risk related on decreasing isolation resistance due to the dust and moisture at the mines. Typically, maintenance interval may be unknown and vary.

An isolation monitoring device may monitor the isolation resistance of the trolley line system and give an alarm when the isolation resistance has decreased below a predetermined value. By just relying on the predetermined isolation measurement limits, e.g. 200 kΩ and 50 kΩ for warning and fault, respectively, the maintenance would have to be done quickly after warning is detected or immediately after a fault to avoid risks related to possibly fatal second isolation fault. The fatal second isolation fault may lead to dangerous touch voltages and cause power supply interruption. Therefore, it is important to clean the isolators regularly.

According to an example embodiment, a maintenance interval and maintenance operations of a trolley line system may be determined in advance based on isolation resistance measurement data. The isolation resistance measurement data may be utilized to predict the isolation resistance from a rate of change of the isolation resistance measurement data. The predicted isolation resistance may be compared to predetermined isolation resistance thresholds indicative of a condition of isolators of the trolley line system. The comparison may indicate time until the maintenance is required at the latest. In an embodiment, the comparison may indicate a time when the maintenance is recommended to be performed. One or more subsequent intervals may be determined with an order of preference associated with the condition of the isolators. An optimal time slot for the maintenance may be searched within the intervals in the preferred order based on operation data indicating possible time slots for the maintenance.

An example embodiment may enable that the interval for maintenance is solved accurately beforehand such that there is no need to wait for an alarm from the isolation monitoring device. This provides significant advantage as the alarm may be given at the time when the isolation resistance has already decreased significantly, and therefore immediate actions may be needed. By predicting the interval for maintenance, there may be sufficiently time to prepare and search for an optimal or a preferred time slot for the maintenance. Hence, operational reliability may be ensured. Because the required maintenance may be anticipated in time, an additional level of isolation of the trolley line system may not be needed. The reduced need for additional level of isolation may enable less complicated and cheaper implementation of the trolley line system. With the less complicated implementation of the trolley line system, easier and faster maintenance of the trolley line system may be achieved. Furthermore, when the trolley line system is located at a production site, such as a mine, operation data of the mine may be utilized to further optimize or improve the time for maintenance. In an embodiment, the maintenance may be determined to the least disturbing time for production at the mine. In addition, other maintenance operations at the mine may be scheduled to the same time to further enhance operations and production at the mine. Reduced downtime of operation as well as increased productivity may be achieved.

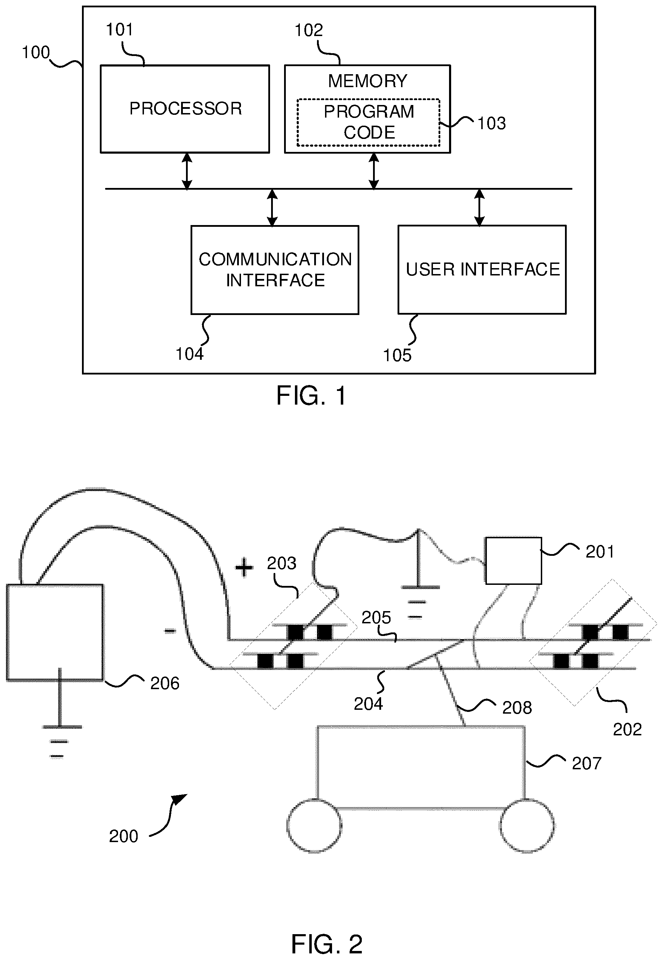

FIG. 1 illustrates an apparatus 100 configured to determine an interval for maintenance of a trolley line system according to an embodiment.

The apparatus 100 may comprise at least one processor 101. The at least one processor 101 may comprise, for example, one or more of various processing devices, such as for example a co-processor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, or the like.

The apparatus 100 may further comprise at least one memory 102. The memory may be configured to store, for example, computer program code 103 or the like, for example operating system software and application software. The memory 102 may comprise one or more volatile memory devices, one or more non-volatile memory devices, and/or a combination thereof. For example, the memory may be embodied as magnetic storage devices (such as hard disk drives, magnetic tapes, etc.), optical magnetic storage devices, or semiconductor memories (such as mask ROM, PROM (programmable ROM), EPROM (erasable PROM), flash ROM, RAM (random access memory), etc.). In an embodiment, the memory 102 may be removably attachable to the apparatus 100, for example, via an external memory interface such as USB (universal serial bus) interface. The memory 102 may be an external memory coupled to the apparatus wirelessly or with a wire.

The apparatus 100 may further comprise a communication interface 104 configured to enable the apparatus 100 to transmit and/or receive information, to/from other apparatuses. The communication interface 104 may be configured to provide at least one wireless radio connection, such as for example a 3GPP mobile broadband connection (e.g. 3G, 4G, 5G). However, the communication interface 104 may be configured to provide one or more other type of connections, for example a wireless local area network (WLAN) connection such as for example standardized by IEEE 802.11 series or Wi-Fi alliance; a short range wireless network connection such as for example a Bluetooth, NFC (near-field communication), or RFID connection; a wired connection such as for example a local area network (LAN) connection, a universal serial bus (USB) connection or an optical network connection, or the like; or a wired Internet connection.

The apparatus 100 may further comprise a user interface 105 comprising an input device and/or an output device. The input device may take various forms such a keyboard, a touch screen, or one or more embedded control buttons. The output device may for example comprise a display, a speaker, or the like.

When the apparatus 100 is configured to implement some functionality, some component and/or components of the apparatus 100, such as for example the at least one processor 101 and/or the memory 102, may be configured to implement this functionality. Furthermore, when the at least one processor 101 is configured to implement some functionality, this functionality may be implemented using program code 103 comprised, for example, in the memory 102.

The functionality described herein may be performed, at least in part, by one or more computer program product components such as software components. According to an embodiment, the apparatus 100 comprises a processor or processor circuitry, such as for example a microcontroller, configured by the program code when executed to execute the embodiments of the operations and functionality described. Alternatively, or in addition, the functionality described herein can be performed, at least in part, by one or more hardware logic components. For example, and without limitation, illustrative types of hardware logic components that can be used include Field-programmable Gate Arrays (FPGAs), application-specific Integrated Circuits (ASICs), application-specific Standard Products (ASSPs), System-on-a-chip systems (SOCs), Programmable Logic Devices (PLD), Complex Programmable Logic Devices (CPLDs), Graphics Processing Units (GPUs).

The apparatus 100 comprises means for performing at least one method described herein. In one example, the means comprises the at least one processor 101, the at least one memory 102 including program code 103 configured to, when executed by the at least one processor 101, cause the apparatus 100 to perform the method.

The apparatus 100 may comprise for example a computing device such as for example a server device, a client device, a mobile phone, a tablet computer, a laptop, or the like. Although the apparatus 100 is illustrated as a single device it is appreciated that, wherever applicable, functions of the apparatus 100 may be distributed to a plurality of devices.

FIG. 2 illustrates an example embodiment of a trolley line system 200 according to an embodiment. The trolley line system 200 may be installed, for example, inside and/or outside a mine to enable mining haulage. The trolley line system 200 may comprise an overhead power source along a haulage road. The overhead power source may be configured to feed power to electric rubber-tired wheel vehicles, such as haulage trucks 207. The haulage trucks 207 may comprise poles or a pantograph 208 to collect power from the overhead power source. The overhead power source comprises at least two overhead lines 204, 205 which may be wires or bus bars suspended above the route of the trolley line system. The overhead lines 204, 205 may be fed by a power source 206 configured to supply DC power. The trolley line system 200 is an IT system, which may be earthed at the power source 206 side and which has no direct connection between the overhead lines 204, 205 and the earth. The overhead lines 204, 205 may be isolated from the earth by the rubber tires of the electric haulage truck 207.

An isolation monitoring device 201 is usually mandatory in IT systems. The isolation monitoring device 201 may be connected between the overhead lines 204, 205 and the earth to provide accurate isolation resistance measurement data of the trolley line system 200. The isolation resistance serves as an important indicator for the condition of isolation of the trolley line system 200. The isolation monitoring may be performed without interrupting the supply and does not affect system operation or the loads connected. An advantage of the IT system is that the trolley line system 200 may continue operation after a first fault, however maintenance must be performed promptly before a second fault occurs. The first fault may refer to an event of a short-circuit to earth in one phase. The second fault is an earth fault affecting a different phase than that of the first fault resulting a short-circuit thought the earth and requires immediate power shut-down. Isolators of the trolley line system 200 need to be maintained preferably in a good time before the first fault to ensure sufficient insulation properties. In an embodiment, the isolation monitoring device 201 may be configured to dispatch the isolation resistance measurement data to an apparatus configured to determine maintenance interval of the trolley line system 200. The apparatus may comprise the apparatus 100. In an embodiment, the isolation monitoring device 201 may dispatch the data in approximately real-time.

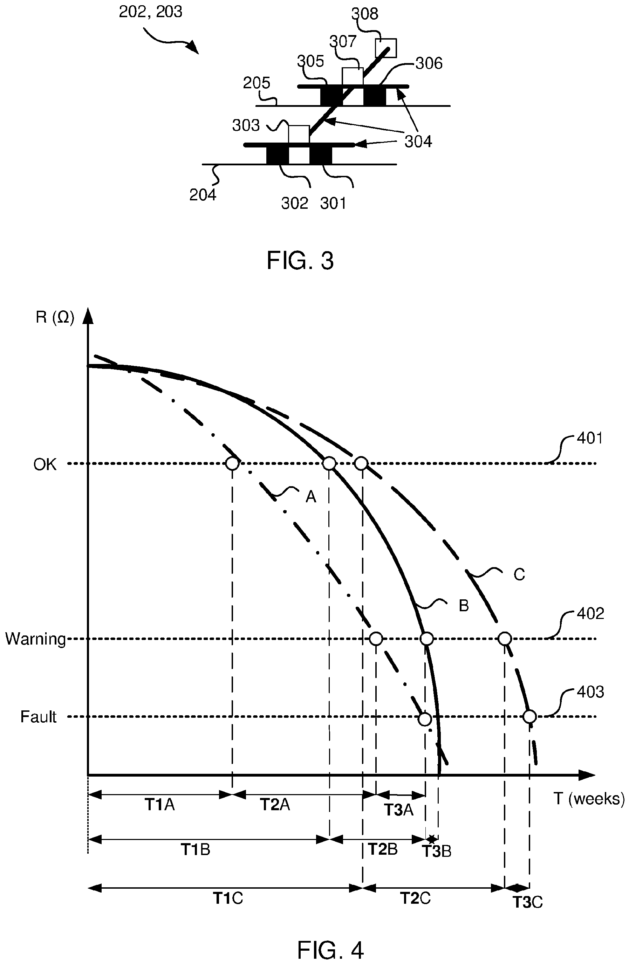

The trolley line system 200 may comprise one or more levels of isolation in support structures 304 of the trolley line system 200. The trolley lines 204, 205 may be long and the support structures with the isolators 202, 203 may be installed at predetermined distances. FIG. 3 illustrates a support structure of the trolley line system 200 comprising at least one level of isolation 202, 203. The first level of isolation may comprise, for example, a pair of isolators 301, 302 coupled to the first overhead line 204 and a pair of isolators 305, 306 coupled to the second overhead line 205 at the support structure point 304. In addition, the trolley line system 200 may comprise a second level of isolators coupled at the support structure 304. The second level of isolation may comprise one or more additional isolators 303, 307, 308 located, for example, above the first level of isolators. The second level of isolators may enhance the isolation against the ground but makes the system more complicated.

In an embodiment, the isolation resistance measurement data may be used to predict the isolation resistance of the trolley line system 200 with respect to time. The predicted isolation resistance may be used to determine the interval for the maintenance by estimating a time until a predetermined threshold indicative of a condition of the isolators is met. The predetermined threshold may indicate, for example, when the isolation resistance is decreased but the isolators may still be in a good condition, when the isolation resistance has decreased to a warning limit or when the first fault may be expected. Based on the interval for maintenance, the maintenance may be scheduled timely. Therefore, possible faults caused by the decreased condition of the isolation system may be avoided. Furthermore, only the first level of isolation may be needed in the trolley line system 200 because the maintenance may be accomplished in time, and hence, there may not be need for a back-up provided by the additional isolators 303, 307, 308. The enabled removal of additional isolation decreases complicity and maintenance costs of the system 200.

In an embodiment, the isolation resistance measurement data may be used to detect deterioration of isolation resistance of an electric vehicle, such as the haulage truck 207, coupled with the trolley line system 200. When the electric vehicle is coupled with the trolley line system 200, the isolation monitoring device 201 may monitor the isolation resistance of the overall system, i.e. comprising isolation resistance associated with the electric vehicle. In response to at least one electric vehicle being coupled with the trolley line system 200, the total insulation resistance of the trolley line system may decrease, for example, due to some flaw in the isolation components of the electric vehicle. In an embodiment, the apparatus may obtain information indicating that at least one electric vehicle is coupled with the trolley line system 200 and the apparatus may be configured to detect a decrease in the isolation resistance measurement data, wherein the decrease is associated with the at least one electric vehicle being coupled with the trolley line system. In an embodiment, the required power of the trolley line system may indicate when there is at least one electric vehicle coupled with the trolley line system 200. In an embodiment, the apparatus may obtain location information of the at least one electric vehicle. The location information may comprise at least one of a geographical location, a speed, or a heading of the electric vehicle. The apparatus may determine the number of electric vehicles coupled to the trolley line system based on at least one of the required power of the trolley line system 200 or the location information of the at least one electric vehicle. Based on the detected decrease in the isolation resistance data and the information indicating that the at least one electric vehicle is coupled with the trolley line system, the apparatus may determine which electric vehicle may have caused the decrease. Hence, maintenance of the electric vehicle may be determined by the apparatus. The maintenance of the electric vehicle may be scheduled to the same time as the maintenance of the isolators of the trolley line system 200.

FIG. 4 illustrates an example diagram of isolation resistance curves A, B, C derived from isolation resistance measurement data associated to a trolley line system according to an embodiment. The isolation resistance measurement data may be obtained from an isolation monitoring device configured to monitor isolation resistance of the trolley line system. In FIG. 4, two isolation resistance curves B, C illustrate the isolation resistance of the trolley line system predicted based on different sets of isolation resistance measurement data. The set of isolation resistance data used for the prediction may comprise data obtained after a previously performed maintenance. The third isolation resistance curve A illustrates an example of a typical isolation resistance curve of the trolley line system. Each isolation resistance measurements may be obtained from the same trolley line system locating in a specific mine. The typical isolation resistance curve A may be obtained based on average values of the isolation resistance measurement data gathered over a long period, such as a year or several months. The typical curve may illustrate an average or a nominal isolation resistance curve, and it may be different for different trolley line systems depending on e.g. environment of the installation site of the trolley line system. The predicted isolation resistance curves B, C may be obtained by determining a rate of change of the isolation resistance based on prevailing isolation resistance data at the time.

Further, one or more isolation resistance thresholds 401, 402, 403 may be determined. The isolation resistance thresholds 401, 402, 403 may be determined, for example, based on existing standards for acceptable limits of isolation resistance or based on the typical isolation resistance curve of the specific mine. In an embodiment, the highest threshold 401 may indicate an "OK" condition of the isolation of the trolley line system, before which the maintenance is preferably performed. The highest isolation resistance threshold 401 may depend on the typical isolation resistance curve of the specific mine such that enough time for the maintenance may be ensured before the isolation resistance decreases significantly, for example, to the next thresholds. For instance, the isolation resistance of the trolley line system may be 18 MΩ immediately after maintenance and between 3 to 1 MΩ at the highest isolation resistance threshold 401, depending on the typical conditions at the mining environment. In an embodiment, the second highest threshold 402 may indicate a "warning" limit, after which the maintenance may be required shortly, for example, within a week. The third threshold 403 may indicate a "fault" limit, after which the maintenance may be required immediately or within the next couple of days. The second and third isolation resistance thresholds 402, 403 may be, for example, standard values of 200kΩ and 50kΩ, respectively. In general, the second isolation resistance threshold 402 may be at least four times greater than the third isolation resistance threshold 403.

The measured and predicted isolation resistance may be compared with the one or more isolation resistance thresholds 401, 402, 403 to determine an interval for maintenance. In an embodiment, the interval for maintenance may be divided to a plurality of intervals based on the isolation resistance thresholds 401, 402, 403. In an embodiment, the interval for maintenance may comprise a primary interval T1A, T1B, T1C in which the isolation resistance A, B, C is above the first isolation resistance threshold 401. In an embodiment, the interval for maintenance may further comprise a secondary interval T2A, T2B, T2C in which the isolation resistance A, B, C is between the first 401 and the second isolation resistance threshold 402. In an embodiment, the interval for maintenance may further comprise a third interval T3A, T3B, T3C in which the isolation resistance A, B, C is between the second isolation resistance threshold 402 and the third isolation resistance threshold 403.

Predicting the isolation resistance based on accurate isolation resistance data may enable optimizing the interval for maintenance. In comparison to the first predicted isolation resistance curve B, the example of the typical isolation resistance curve A decreases faster and the second predicted isolation resistance curve C slower than in the first prediction. The different rates of change of the isolation resistance may affect the intervals for maintenance. As shown in FIG. 4, the total interval T1A, T2A, T3A comprising the primary, secondary and third interval is shorter for the typical isolation resistance curve A than the intervals for maintenance T1B, T2B, T3B; T1C, T2C, T3C of the other isolation resistance curves B, C. Also, the total interval for maintenance T1C, T2C, T3C of the second predicted isolation resistance curve C is considerably longer than for the other curves A, B. If the maintenance interval was estimated simply based on the typical rate of change, the maintenance may be performed too early or too late. Hence, the prediction based on the recent isolation resistance measurement data may enable optimizing the interval for maintenance such that the maintenance may be determined for the right time which may depend on prevailing conditions at the mine. The conditions affecting the rate of change of the isolation resistance may comprise, for example, a production rate at the mine or a malfunctioning device causing a decrease in condition of the isolators.

In an embodiment, the rate of change of the predicted isolation resistance B, C may be compared to the typical rate of change (curve A) to detect deviation from the typical rate of change. The deviation may indicate a change to a normal operation of the mine. In response to detecting the deviation, a cause of the deviation may be determined, for example, based on operation data of the mine. For example, the production at the mine may have been lower during the isolation resistance curve C that decreases slower, while production may have increased resulting in higher amount of dust in the air, which resulted in faster deterioration of isolation resistance B. The operation data associated with the measured and predicted isolation resistance may be used to indicate, for example, that some process or component of the mine is malfunctioning. Typically, infrastructure of the mine may be implemented such that ventilation ducts, electric cabling and water hoses are done in the same structure or directly above the trolley lines. For example, a ventilation system of the mine may not work like earlier and therefore there is more dust and moisture in the air. In an embodiment, the detected deterioration in the rate of change of the isolation resistance may be compared to the operation data to indicate a possible failure in the ventilation system. Similarly, a water pipe or hose may have started to leak, or water starts to drip through the rock after blasting. The water may cause faster deterioration in the isolation resistance, which may be detected based on the changed rate of change and the operation data associated to the time of the change.

The prediction of the maintenance interval may benefit overall operations of the mine. At mines, machine fleet, infrastructure like IT, water, pressurized air, electric networks and ventilation systems all need maintenance. When the interval for maintenance of the trolley line system is known, the other maintenance operations at the mine may be scheduled at the same time as the maintenance of the trolley line system to minimize disturbances to the processes. Hence, reduced downtime of operation and increased productivity may be further enhanced.

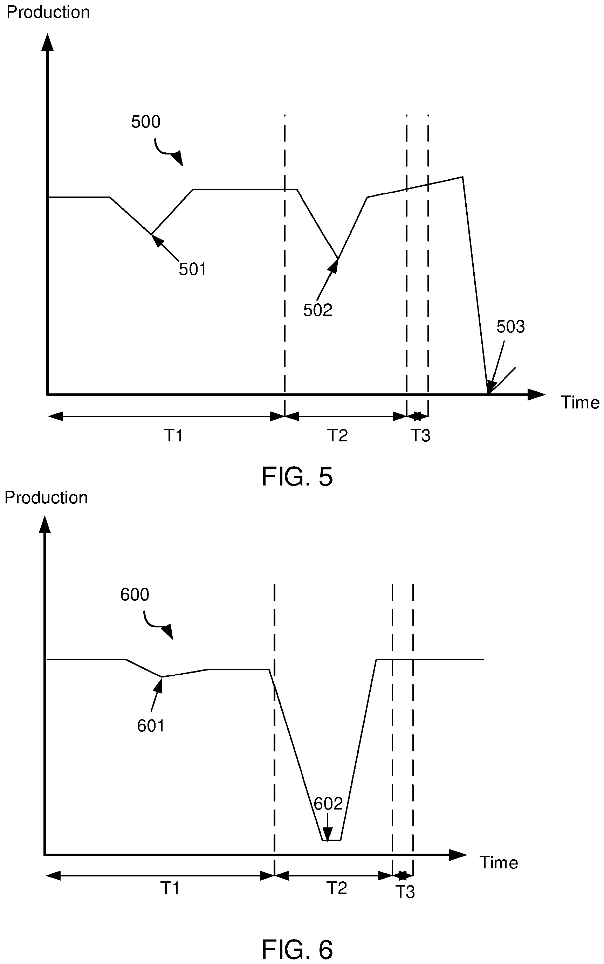

FIG. 5 illustrates a diagram of operation data 500 and possible time slots 501, 502, 503 for maintenance of a trolley line system within an interval for maintenance according to an embodiment. The operation data 500 may be associated to operations of a production site comprising the trolley line system. In an embodiment the production site is a mine. The operation data 500 is illustrated as a production rate, but it may comprise a variety of information associated to the operations, processes and devices at the production site. In an embodiment, the operation data may be obtained from a task management system of the production site.

From the operation data it may be determined when there is a possible time slot 501, 502, 503 with a relatively low production rate or no production at all. Further, from the measured and predicted isolation resistance it may be predicted when the maintenance is needed, as described earlier. In an embodiment, the interval for maintenance may comprise at least one of a primary interval T1, a secondary interval T2 or a third interval T3. Based on the operation data 500, it may be determined if the trolley line system maintenance may take place in the coming time slot suitable for production or not. Based on a comparison of the operation data and the interval(s) for maintenance, a suitable time for the trolley line system maintenance may be found minimizing disturbances to production.

From the operation data 500, it may be detected that there are three possible time slots 501, 502, 503 for maintenance based on decreased production. In an embodiment, the possible time slots 501, 502, 503 for maintenance may be compared to the interval for maintenance T1, T2, T3 to detect an optimal time slot for the maintenance. The optimal time slot may be determined from the possible time slots 501, 502, 503 which locate within the interval T1, T2, T3. In an embodiment, the optimal time slot is determined as the possible time slot 501 within the interval T1, T2, T3 which comes the earliest. In an embodiment, the possible time slots 501, 502, 503 may be first compared to the primary interval T1 and, if there is at least one possible time slot 501 within the primary interval T1, the optimal time slot is determined from the at least one possible time slot 501. If none of the possible time slots 501, 502, 503 are located within the primary interval T1, the possible time slots 501, 502, 503 may be next compared to the secondary time interval T2 to determine the optimal time slot from the possible time slots 502 locating within the secondary interval T2. In an embodiment, if none possible time slots are detected within the primary and the secondary interval T1, T2, the possible time slots 501, 502, 503 may be compared to the third interval T3. In an embodiment, if none possible time slots are detected within the interval T1, T2, T3, maintenance may be determined within the primary interval T1. The maintenance may be preferably performed within the primary interval T1 and at least within the secondary interval T2. In exceptional situations where no optimal time slot is detected within the previous intervals, or there is no time to arrange maintenance before the third interval T3, the maintenance may be determined within the third interval T3.

FIG. 6 illustrates a diagram of operation data 600 and possible time slots 601, 602 for maintenance within an interval for maintenance T1, T2, T3 according to another embodiment. Based on the operation data 600, two possible time slots for maintenance 601, 602 may be determined. The second possible time slot 602 has a substantially lower production rate, which may be caused, for example, by a scheduled maintenance at the production site causing a large disruption for the production. In an embodiment, the optimal time slot for maintenance within the interval for maintenance T1, T2, T3 may be determined to be the possible time slot 602 having the lowest degree of production. In an embodiment, the primary interval for maintenance T1 may be preferred such that the possible time slot 602 with the lower production than the possible time slot 601 within the primary interval T1 is selected only if the difference in the lowered production rate is substantial. Hence, at least one of timing or degree of production may be emphasized when determining the optimal time slot to take into account the condition of the isolation as well as disturbance caused for the production.

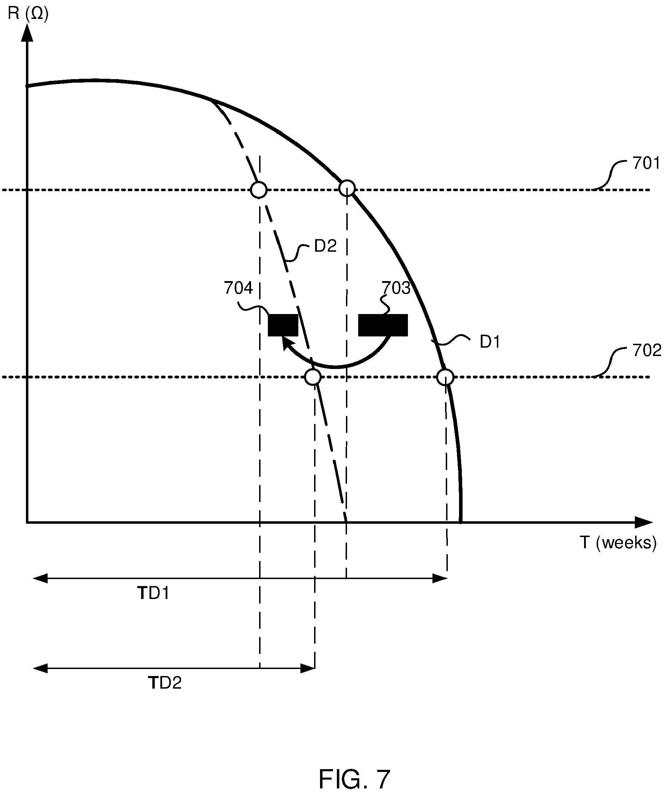

FIG. 7 illustrates a diagram of predicted isolation resistance D1, D2 wherein an optimal time slot for maintenance 703, 704 changes due to a change in the prediction according to an embodiment. The prediction may change, for example, in response to a sudden event increasing a level of dust in the air. Such event may be, for example, a breakage of a ventilation system. Therefore, the optimal time slot for maintenance may have changed and it may be redetermined based on a corrected interval for maintenance.

Based on isolation resistance measurement data of a trolley line system and a rate of change of the measured isolation resistance, the isolation resistance may be predicted to correspond to an isolation resistance curve D1. The rate of change of the isolation resistance measurement data may be monitored to detect a possible substantial change in the rate of change. The substantial change in the rate of change may affect the predicted isolation resistance and an interval for maintenance, respectively. The substantial change in the rate of change of the isolation resistance measurement data may result a new prediction for the isolation resistance corresponding to an isolation resistance curve D2. The illustrated new curve D2 decreases faster than the firstly predicted isolation resistance curve D1 due to the sudden reduction in air quality. In response to comparing the isolation resistance curve D2 to predetermined isolation resistance thresholds 701, 702, a new interval for maintenance TD2 may be determined. The new interval for maintenance TD2 may be shorter or longer than the firstly determined interval for maintenance TD1.

In an embodiment, the previously determined optimal time slot 703 within the interval for maintenance TD1 is too late with respect to the new interval TD2. The possible time slots for maintenance may be compared to the new interval TD2 to detect a new optimal time slot 704 for the maintenance. Hence, the interval for maintenance may be optimized on the fly to ensure the maintenance is performed in time. For example, if the maintenance interval was not corrected based on the measured and predicted isolation resistance, an isolation monitoring device may have had triggered a warning at the time the measured isolation resistance had already passed the second isolation resistance threshold 702. At the time of the warning, there may not be enough time to organize the maintenance or it may cause considerable disruption for production.

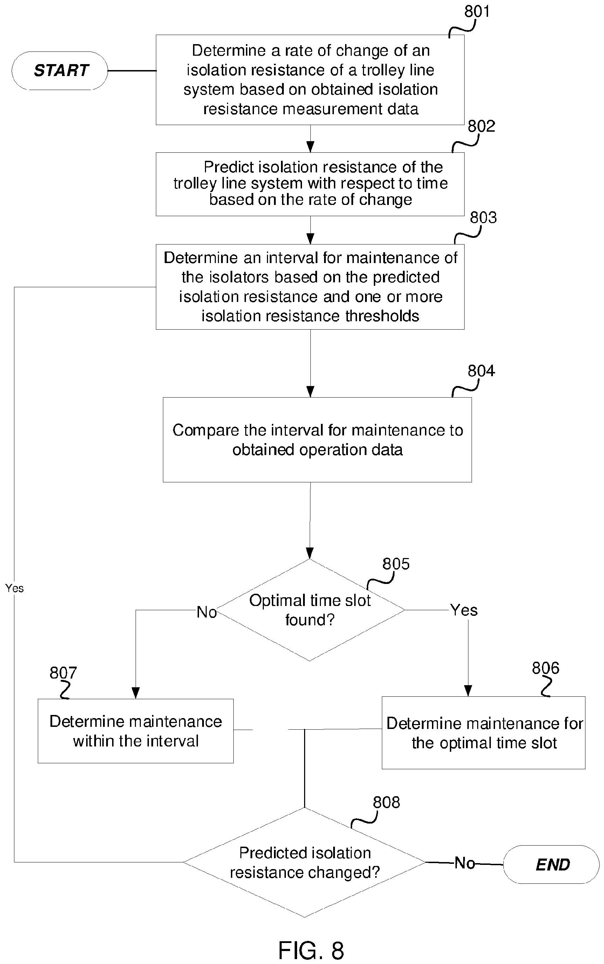

FIG. 8 illustrates a flowchart of operation of an apparatus, such as the apparatus 100, for determining a maintenance interval of a trolley line system according to an embodiment.

At 801, a rate of change of an isolation resistance of a trolley line system may be determined based on obtained isolation resistance measurement data. The isolation resistance data may be obtained by the apparatus from an isolation resistance measurement device configured to measure the isolation resistance of the trolley line system.

At 802, isolation resistance of the trolley line system with respect to time may be predicted based on the rate of change.

At 803, an interval for maintenance of the isolators is determined based on the predicted isolation resistance and one or more isolation resistance thresholds. The isolation resistance thresholds may be predetermined by the apparatus, for example, based on a user input or based on a typical rate of change of the isolation resistance of the specific trolley line system.

At 804, the interval for maintenance may be compared to obtained operation data. The operation data may be obtained, for example, from a task management system of a mine or from a plurality of data sources associated to operation of the mine.

At 805, it may be determined if an optimal time slot for maintenance is detected based on the comparison. In an embodiment, the apparatus may determine one or more possible time slots for maintenance based on the operation data, and the optimal time slot for maintenance may be determined among the possible time slots which locate within the interval for maintenance. The optimal time slots may comprise, for example, decreased production and/or an already scheduled maintenance at the mine. In an embodiment, the optimal time slot for maintenance may be selected from the possible time slots within the interval such that the possible time slot during which production is the lowest is selected. In an embodiment, the optimal time slot for maintenance may be selected from the possible time slots within the interval such that the possible time slot during which the other maintenance operation is already scheduled is selected. In an embodiment, the interval may comprise a plurality of subintervals, and the possible time slots for maintenance may be first compared to the earliest subinterval. If there are no possible time slots within the earliest subinterval, the possible time slots may be compared to the next subintervals in a chronological order until the optimal time slot is detected. In an embodiment, the optimal time slot for maintenance may be determined based on the earliest possible time slot within the interval.

If there are no possible time slots for maintenance based on the operation data, or if there are no possible time slots within the interval, the apparatus may determine the maintenance within the interval at operation 807. In an embodiment, the maintenance may be determined within the earlies subinterval in response to not detecting the optimal time slot at 805. Hence, even though there may not be an optimal time slot for the maintenance within the interval based on the operation data, it may be ensured that the maintenance is performed appropriately and in time. Further, the maintenance may be scheduled in advance so that it is possible to schedule other maintenance operations at the same time with the maintenance of the trolley line system. This may enable streamlining operations at the production site with minimal amount of disruptions.

If the optimal time slot for maintenance is found based on the comparison at 805, the maintenance of the trolley line system may be determined for the optimal time slot at operation 806. After the maintenance is determined for the optimal time slot, also other maintenance operations at the production site may be planned to be performed at the same time. Overall disruptions caused by maintenance work may be thus minimized or decreased.

At 808, the apparatus may monitor if there are changes in the isolation resistance measurement data resulting substantial changes in the predicted isolation resistance with respect to time. The substantial changes in the predicted isolation resistance may cause also changes in the interval for maintenance. Therefore, the process may return to operation 803 if the predicted isolation resistance has substantially changed. If the predicted isolation resistance remains approximately the same, no further operations may be required. The substantial change may be greater than normal deviation in measurements. In an embodiment, the process may be repeated after each maintenance. In an embodiment, the apparatus may be configured to notify an operator of the production site about the detected deviation in the rate of change. In an embodiment, the apparatus may be configured to determine a cause of the deviation based on operation data. In an embodiment, the apparatus may notify the operator about the possible cause of the deviation.

Further features of the method(s) directly result for example from functionalities of the apparatus described throughout the specification and in the appended claims and are therefore not repeated here. Different variations of the method(s) may be also applied, as described in connection with the various example embodiments.

An apparatus may be configured to perform or cause performance of any aspect of the method(s) described herein. Further, a computer program may comprise instructions for causing, when executed, an apparatus to perform any aspect of the method(s) described herein. Further, an apparatus may comprise means for performing any aspect of the method(s) described herein. According to an example embodiment, the means comprises at least one processor, and memory including program code, the at least one processor, and program code configured to, when executed by the at least one processor, cause performance of any aspect of the method(s).

Any range or device value given herein may be extended or altered without losing the effect sought. Also, any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The operations of the methods described herein may be carried out in any suitable order, or simultaneously where appropriate. Additionally, individual blocks may be deleted from any of the methods without departing from the scope of the subject matter described herein. Aspects of any of the embodiments described above may be combined with aspects of any of the other embodiments described to form further embodiments without losing the effect sought.

The term 'comprising' is used herein to mean including the method, blocks, or elements identified, but that such blocks or elements do not comprise an exclusive list and a method or apparatus may contain additional blocks or elements.

Although subjects may be referred to as 'first' or 'second' subjects, this does not necessarily indicate any order or importance of the subjects. Instead, such attributes may be used solely for the purpose of making a difference between subjects.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from scope of this specification.

## Claims

1. A method, comprising:
obtaining isolation resistance measurement data associated to a trolley line system;
determining a rate of change of the isolation resistance based on the isolation resistance measurement data;
predicting isolation resistance of the trolley line system with respect to time based on the rate of change;
determining one or more isolation resistance thresholds indicative of a condition of the isolators; and
determining an interval for maintenance of the isolators based on the predicted isolation resistance and the one or more isolation resistance thresholds, wherein the interval is indicative of a time when the one or more isolation resistance thresholds are met by the predicted isolation resistance.

2. The method of claim 1, comprising:
obtaining operation data;
determining one or more possible time slots for maintenance based on the operation data;
comparing the possible time slots to the interval for maintenance to detect an optimal time slot from the possible time slots, wherein the optimal time slot is located within the interval; and
determining the maintenance of the isolators for the optimal time slot.

3. The method of claim 2, wherein the operation data is associated to operations of a production site comprising the trolley line system; and
the possible time slot is associated with at least one of a decreased production or a scheduled maintenance at the production site.

4. The method of claim 2 or 3, wherein the optimal time slot for maintenance is the earliest possible time slot within the interval.

5. The method of claim 3, wherein the optimal time slot for maintenance is the possible time slot within the interval which has the lowest production.

6. The method of any of the claims 2 to 5, wherein the interval for maintenance comprises a primary interval in which the predicted isolation resistance is above a first isolation resistance threshold and a secondary interval in which the predicted isolation resistance is between the first and a second isolation resistance threshold;
and wherein the possible time slots are compared to the primary interval; and
in response to not detecting possible time slots locating within the primary interval, the possible time slots are compared to the secondary interval.

7. The method of claim 6, wherein the interval for maintenance comprises a third interval in which the predicted isolation resistance is between the second and a third threshold; and
in response to not detecting possible time slots locating within the primary and the secondary interval, the possible time slots are compared to the third interval.

8. The method of claim 6 or 7, further comprising:
determining the maintenance within the primary interval when there are no possible time slots locating within the interval.

9. The method of any of the claims 2 to 8, further comprising:
determining a typical rate of change of the isolation resistance based on previously measured isolation resistance data of the isolators;
comparing the determined rate of change to the typical rate of change to detect deviation from the typical rate of change; and
determining a cause of the deviation based on the operation data.

10. The method of any preceding claim, comprising:
detecting a substantial change in the predicted isolation resistance; and
correcting the interval for maintenance based on the substantial change in the predicted isolation resistance and the isolation resistance thresholds.

11. The method of claim 10, further comprising:
determining a cause of the substantial change in the predicted isolation resistance based on the operation data.

12. The method of any preceding claim, comprising:
obtaining information indicating that at least one electric vehicle is coupled with the trolley line system;
detecting a decrease in the isolation resistance in response to the at least one electric vehicle being coupled with the trolley line system based on the isolation resistance measurement data;
determining the electric vehicle associated with the decrease based on the information; and
determining a maintenance of the electric vehicle simultaneously with maintenance of the trolley line system.

13. An apparatus, comprising:
at least one processor; and
at least one memory comprising a program code which, when executed by the at least one processor, causes the apparatus to perform the method of any of the claims 1 to 12.

14. A trolley line system comprising an isolation monitoring device configured to dispatch isolation resistance measurement data associated to the trolley line system to the apparatus of claim 13.

15. A computer program comprising program code which, when executed by at least one processing unit, causes the at least one processing unit to perform the method of any of the claims 1 to 12.
